Europäisches Patentamt

European Patent Office

Office européen des brevets

(19)

(11) Veröffentlichungsnummer: **0 282 617**
**A1**

(12) **EUROPÄISCHE PATENTANMELDUNG**

(21) Anmeldenummer: **87103957.4**

(22) Anmeldetag: **18.03.87**

(51) Int. Cl.⁴: **H01L 23/48** , H01L 23/56

Die Bezeichnung der Erfindung wurde geändert (Richtlinien für die Prüfung im EPA, A-III, 7.3).

(43) Veröffentlichungstag der Anmeldung:
**21.09.88 Patentblatt 88/38**

(84) Benannte Vertragsstaaten:
**AT BE CH DE ES FR GB GR IT LI LU NL SE**

(71) Anmelder: **TEXAS INSTRUMENTS DEUTSCHLAND GMBH**
**Haggertystrasse 1**
**D-8050 Freising(DE)**

(72) Erfinder: **Schürmann, Josef**
**Nr. 42**
**D-8051 Oberhummel(DE)**

(74) Vertreter: **Schwepfinger, Karl-Heinz, Dipl.-Ing. et al**
**Prinz, Leiser, Bunke & Partner Manzingerweg 7**
**D-8000 München 60(DE)**

(54) **Integrierte Schaltung mit einer elektrisch leitenden Trägerplatte.**

(57) Es wird eine integrierte Schaltung beschrieben, die ein eine elektronische Schaltung enthaltendes Halbleiterplättchen (I0) enthält, das auf einer Trägerplatte (I2) aus elektrisch leitendem Material angebracht ist. Im wesentlichen in der Ebene der Trägerplatte (I2) sind Leiterstreifen (I8) angeordnet, die sich in Richtung zu der Trägerplatte (I2) hin erstrecken und an ihrem von der Trägerplatte (I2) abgewandten Ende als Anschlußleiter (22) zum Herstellen von Verbindungen zu externen elektronischen Schaltungen ausgebildet sind. Ausgewählte Leiterstreifen (I8) sind mit ausgewählten Punkten der elektronischen Schaltung in dem Halbleiterplättchen (I0) verbunden. Es ist ein die Trägerplatte (I2), das Halbleiterplättchen (I0) und die Leiterstreifen (I8) umschließendes Gehäuse versehen, aus dem die Anschlußleiter (22) nach außen ragen. Wenigstens einer dieser Anschlußleiter (22) dient dem Anlegen von Masse. Die Trägerplatte (I2) ist in Rich tung zu dem den Anlegen von Masse dienenden wenigstens einen Anschlußleiter (22) hin versetzt und/oder einstückig mit Masse verbunden.

FIG. 1

## Integrierte Schaltung

Die Erfindung bezieht sich auf eine integrierte Schaltung mit einem eine elektronische Schaltung enthaltenden Halbleiterplättchen, einer Trägerplatte aus elektrisch leitendem Material, auf der das Halbleiterplättchen angebracht ist, in der Ebene der Trägerplatte angeordneten Leiterstreifen, die sich in Richtung zu der Trägerplatte hin erstrecken und an ihren von der Trägerplatte abgewandten Enden als Anschlußleiter zum Herstellen von Verbindungen zu externen elektronischen Schaltungen ausgebildet sind, wobei ausgewählte Leiterstreifen mit ausgewählten Punkten der elektronischen Schaltung in dem Halbleiterplättchen in Verbindung stehen, und einem die Trägerplatte, das Halbleiterplättchen und die Leiterstreifen umschließenden Gehäuse, aus dem die Anschlußleiter nach außen ragen, von denen wenigstens einer dem Anlegen von Masse dient.

Integrierte Schaltungen dieser Art werden derzeit in sehr großem Umfang für die verschiedensten Anwendungsgebiete eingesetzt. Insbesondere die Computertechnik wäre ohne die Entwicklung modernen integrierter Schaltungen nicht denkbar. Gerade für das Gebiet der Computertechnik sind integrierte Schaltungen in CMOS-Technologie oder in Bipolar-Technologie entwickelt worden, mit deren Hilfe Schaltvorgänge mit immer größeren Geschwindigkeiten durchgeführt werden können. Es sind bereits Schaltzeiten im Bereich von Nanosekunden oder weniger erreicht worden, was dementsprechend schnelle Computer ermöglicht. Bei der Entwicklung solcher integrierter Schaltungen, die sehr kurze Schaltzeiten ermöglichen, sind jedoch Grenzen erreicht worden, die nicht auf die bei der Verwirklichung der elektronischen Schaltung im Halbleiterplättchen angewendeten Technologie, sondern auf die derzeit üblichen Gehäuseformen zurückzuführen sind. Die Leiterstreifen, über die die Verbindung zwischen der elektronischen Schaltung auf dem Halbleiterplättchen und den externen Schaltungen hergestellt werden, weisen eine bestimmte geometrische Länge auf, so daß sie sich bei hohen Frequenzen wie eine Induktivität verhalten, die einer schnellen Schaltgeschwindigkeit entgegenwirkt. Das Vorhandensein der nicht vernachlässigbaren Leitungsinduktivität der Leiterstreifen hat einen - schwerwiegenden Nachteil, der es nahezu unmöglich macht, die hohen Schaltgeschwindigkeiten auszunutzen, die aufgrund der Halbleitertechnologie bereits mit der elektronischen Schaltung in einem Halbleiterplättchen erreicht werden könnten. Bei einem schnellen Stromanstieg in dem dem Zuführen des Massepotentials dienenden Leiterstreifen wird in diesem Leiterstreifen eine Spannung induziert, die den Massepe gel am Halbleiterplättchen kurzzeitig anhebt. Dies kann so weit gehen, daß die Schaltschwelle der Schaltung überschritten wird, so daß an einem mit einem Ausgang verbundenen Leiterstreifen der Übergang von einem signifikanten Signalpegel (L-Pegel) zu dem anderen signifikanten Signalpegel (H-Pegel) vorgetäuscht wird, ohne daß eine Eingangssignaländerung vorhanden ist. Der Anwendung immer schnellerer Schaltgeschwindigkeiten werden dadurch Grenzen gesetzt.

Dieses Problem der Anhebung des Massepotentials bei hohen Schaltgeschwindigkeiten hat zu integrierten Schaltungen geführt, die bis zu vier Masseanschlüsse aufweisen mit dem Ziel, die elektronische Schaltung auf dem Halbleiterplättchen stärker auf das Massepotential festzulegen. Ein Beispiel für eine solche Lösung findet sich in der 1986 erschienenen Broschüre der Firma Texas Instruments mit dem Titel "Enhanced Performance Implanted CMOS (EPIC) Advanced CMOS Logic (ACL)" von Martha M. Weinstein et al. Diese Lösung geht jedoch auf Kosten der Größe der integrierten Schaltung, so daß sie der angestrebten Miniaturisierung entgegenwirkt und daher nicht in allen Fällen angewendet werden kann. Außerdem wird bei dieser Lösung nach wie vor jeder einzelne der auf Massepotential gelegten Leiterstreifen über einen sehr dünnen Bonddraht mit Massepunkten der elektronischen Schaltung auf dem Halbleiterplättchen verbunden, so daß immer noch eine nicht vernachlässigbare Leitungsinduktivität zwischen den außerhalb des Gehäuses liegenden Masseanschlußleitern und der elektronischen Schaltung vorhanden ist.

Der Erfindung liegt die Aufgabe zugrunde, eine integrierte Schaltung der eingangs geschilderten Art zu schaffen, bei der die aufgrund der Halbleitertechnologie möglichen hohen Schaltgeschwindigkeiten die auf dem Halbleiterplättchen enthaltenen elektronischen Schaltungen wesentlich besser ausgenutzt werden können.

Dies wird gemäß der Erfindung dadurch erreicht, daß die Trägerplatte in Richtung zu dem dem Anlegen von Masse dienenden wenigstens einen Anschlußleiter hin versetzt ist.

Eine weitere Lösung dieser Aufgabe besteht darin, daß die Trägerplatte einstückig mit dem wenigstens einen dem Anlegen von Masse dienenden Anschlußleiter verbunden ist. Außerdem wird die der Erfindung zugrundeliegende Aufgabe dadurch gelöst, daß die Trägerplatte in Richtung zu dem dem Anlegen von Masse dienenden wenigstens einen Anschlußleiter hin versetzt und einstückig mit diesem Anschlußleiter verbunden ist.

Bei den erfindungsgemäßen integrierten Schaltungen ist die Serieninduktivität zwischen dem den Anlegen von Masse dienenden Anschlußleiter und der elektronischen Schaltung auf dem Halbleiterplättchen wesentlich reduziert, so daß deutlich höhere Schaltgeschwindigkeiten erzielt werden können, ohne daß die oben geschilderten Nachteile auftreten. Es genügt, einen einzigen Masseanschlußleiter zu verwenden, so daß keine Vergrößerung der Abmessungen der integrierten Schaltung erforderlich sind, um die höheren Schaltgeschwindigkeiten zu ermöglichen.

Vorteilhafte Weiterbildungen der Erfindung sind in den Unteransprüchen gekennzeichnet.

Weitere Vorteile der erfindungsgemäßen integrierten Schaltung gehen aus der nachfolgenden Beschreibung von Ausführungsbeispielen der Erfindung hervor, in der auf die Zeichnung Bezug genommen wird. In der Zeichnung zeigen:

Fig. I eine Draufsicht auf die Anordnung der Trägerplatte und der Leiterstreifen in einer integrierten Schaltung nach der Erfindung,

Fig. 2 eine ähnliche Ansicht wie in Fig. I einer weiteren Ausführungsform der Erfindung,

Fig. 3 eine Weiterbildung der Ausführung von Fig. I, die sich besonders für die Anwendung bei Hochfrequenzschaltungen eignet,

Fig. 4 eine Weiterbildung der Ausführung von Fig. 2, ebenfalls mit besonderer Eignung für die Anwendung bei Hochfrequenzschaltungen,

Fig. 5 eine Weiterbildung der in Fig. I dargestellten Anordnung mit Maßnahmen zur Verhinderung des Nebensprechens zwischen Ausgangsleitern, und

Fig. 6 einen Schnitt längs der Linie 6-6 von Fig. I.

In Fig. I ist der innere Aufbau einer integrierten Schaltung in einem DIL-Gehäuse oder einem SO-Gehäuse dargestellt. Die Erfindung kann aber auch bei PLCC-Gehäusen oder ähnlichen Gehäusen angewendet werden. Als Kernstück enthält die integrierte Schaltung ein Halbleiterplättchen I0, in dem unter Anwendung der bekannten Diffusions-oder Implantationsverfahren eine elektronische Schaltung verwirklicht ist. Das Halbleiterplättchen I0 ist mittels eines leitenden Klebstoffs mit einer Trägerplatte I2 verbunden.

Zum Zuführen der Versorgungsspannung sowie zum Anlegen von Eingangssignalen sowie zum Ableiten von Ausgangssignalen sind auf dem Halbleiterplättchen I0 Kontaktstellen I4 angebracht, die über Bonddrähte I6 mit Leiterstreifen I8 in Verbindung stehen. Die Leiterstreifen I8 liegen im wesentlichen in der gleichen Ebene wie die Trägerplatte I2; die Oberfläche der Trägerplatte liegt lediglich geringfügig tiefer als die Oberfläche der Leiterstreifen I8, damit die Oberfläche des auf der Trägerplatte I2 angebrachten Halbleiterplättchens I0 nicht zu weit über der Oberfläche der Leiterstreifen I8 zu liegen kommt. Da das Halbleiterplättchen jedoch sehr dünn ist, ist die Absenkung der Trägerplatte I2 gegenüber den Leiterstreifen I8 ebenfalls nur gering.

Das Halbleiterplättchen I0, die Trägerplatte I2 und die Leiterstreifen I8 sind mit einer Kunststoffmasse umgossen, die das Gehäuse 20 der integrierten Schaltung bildet. Dieses Gehäuse 20 ist in Fig. I in seinem Umriß mit gestrichelter Linie angegeben; er hat eine rechtwinklige Grundform mit einer Längssymmetrieebene 20a und einer Quersymmetrielinie 20b.

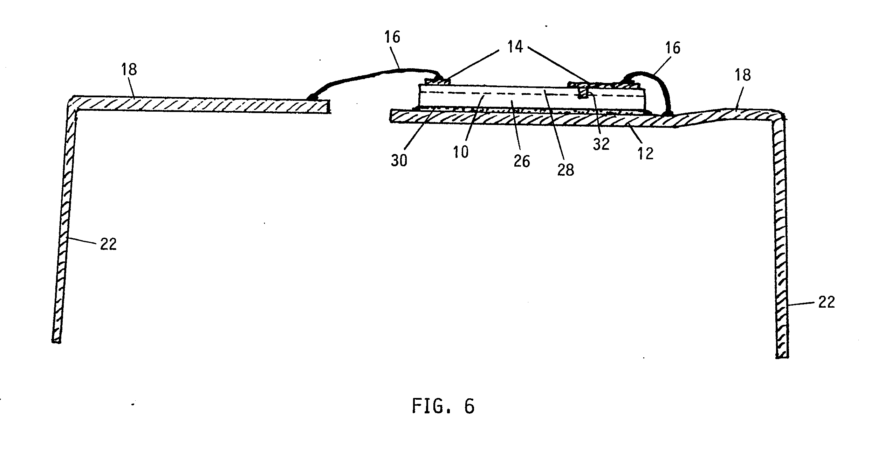

Die Leiterstreifen I8 sind an den von der Trägerplatte I2 entfernt liegenden Enden als Anschlußleiter 22 ausgebildet, die aus dem Gehäuse 20 nach außen ragen. Diese Anschlußleiter 22 sind unmittelbar nach dem Heraustreten aus dem Gehäuse 20 nahezu rechtwicklig umgebogen, und sie können im Anschlußsockel eingesteckt oder auch direkt auf gedruckte Schaltungsplatten gelötet werden. In der Schnittansicht von Fig. 6 ist diese Abwinklung der Anschlußleiter 22 zu erkennen.

Bei derzeit üblichen integrierten Schaltungen wird von den verschiedenen Herstellern ein bestimmtes An schlußschema eingehalten, insbesondere was das Anlegen der Versorgungsspannung anbelangt. Zur Erzielung dieser Vereinheitlichung ist die Art der Numerierung der aus dem Gehäuse 20 nach außen ragenden Anschlußleiter 22 festgelegt, wobei in der Ansicht von Fig. I die Zählung mit dem links unten liegenden Anschlußleiter beginnt und dann gegen den Uhrzeigersinn fortgesetzt wird. Bei der in Fig. I dargestellten Ausführung der integrierten Schaltung liegen die Anschlußleiter I bis I0 auf der in der Darstellung unten liegenden Seite der integrierten Schaltung, und die Anschlußleiter II bis 20 liegen auf der oben liegenden Seite. Der Anschlußleiter Nr. 5 dient bei dieser Ausführungsform dem Anlegen von Masse, und der Anschlußleiter Nr. I5 dient der Verbindung mit der positiven Klemme der Versorgungsspannungsquelle.

Wie aus der Darstellung von Fig. I zu erkennen ist, ist die Trägerplatte I2 in Richtung zu dem dem Anlegen von Masse dienenden Anschlußleiter versetzt, so daß der vom Anschlußleiter 22 zur Trägerplatte führende Leiterstreifen I8 stark verkürzt wird. Außerdem ist der Leiterstreifen I8 einstückig mit der Trägerplatte I2 verbunden, so daß sich eine sehr gute Masseverbindung ergibt. Die Verkürzung des Leiterstreifens I8 bewirkt auch eine deutliche Reduzierung der Serieninduktivität dieses Leiterstreifens, was sich günstig auf das Hochfrequenzverhalten auswirkt. Zum Anlegen von Masse an die im Halbleiterplättchen I0 enthaltene elektronische Schaltung genügt es, einen sehr kurzen Bonddraht I6 zwischen der Trägerplatte und

der entsprechenden Kontaktstelle 14 auf dem Halbleiterplättchen 10 anzubringen. Die zwischen dem Anschlußleiter 22 und der dem Anlegen von Masse dienenden Kontaktstelle 14 auf dem Halbleiterplättchen 10 wirksame Serieninduktivität wird auf diese Weise gering gehalten. Die niedrige Serieninduktivität hat zur Folge, daß das Massepotential in der elektronischen Schaltung im Halbleiterplättchen 10 nicht wesentlich angehoben wird, wenn ein Stromimpuls mit steiler Schaltflanke über den Anschlußleiter 22 und den Leiterstreifen 18 zur elektronischen Schaltung im Halbleiterplättchen 10 fließt. Durch das versetzte Anbringen der Trägerplatte 12 wird Platz geschaffen, der es ermöglicht, den Leiterstreifen 18 breiter auszubilden, der dem Anlegen der positiven Versorgungsspannung dient. Dadurch wird ebenfalls eine Herabsetzung der Serieninduktivität in diesem Anschlußleiter erreicht.

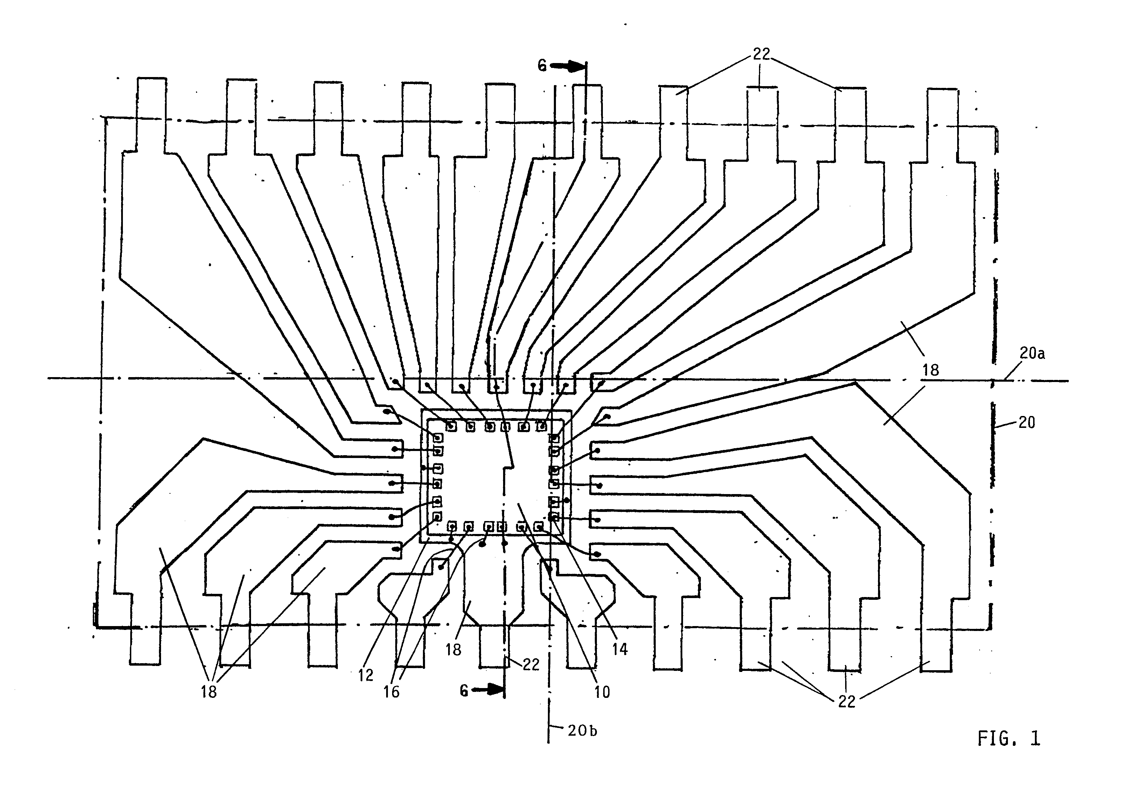

Sollte es sich als notwendig erweisen, mehrere Kontaktstellen 14 auf dem Halbleiterplättchen 10 an Masse zu legen, dann kann dies einfach dadurch erreicht werden, daß die entsprechende Kontaktstelle 14 über einen sehr kurzen Bonddraht direkt mit der an Masse liegenden Trägerplatte 12 verbunden wird. Dies ist in Fig. 1 an mehreren Stellen verdeutlicht.

Sollte es sich als notwendig erweisen, eine weitere Herabsetzung der Serieninduktivität im Masseleiter zu erreichen, dann könnten beispielsweise zwei, drei oder sogar vier Leiterstreifen direkt mit der Trägerplatte einstückig verbunden werden, wobei dann an die vier entsprechenden Anschlußleiter 22 dieser Leiterleiter 18 jeweils Masse von außen her angelegt wird.

Bei der Ausführung von Fig. 1 ist die Trägerplatte 12 nicht nur in Richtung zu dem dem Anlegen von Masse dienenden Anschlußleiter 18 versetzt, sondern sie ist auch in der Darstellung von Fig. 1 zu einer Schmalseite des Gehäuses 20 hin versetzt, was eine weitere vorteilhafte Wirkung ergibt. Für die Erzielung schneller Schaltflanken sind besonders die Serieninduktivitäten der zu den Schaltungsausgängen führenden Leiterstreifen 18 von Bedeutung. Ferner ist die bei hohen Ausgangsströmen in benachbarten Leitern hervorgerufene gegenseitige Beeinflussung durch Schaltvorgänge, also das Übersprechen, proportional zur Leiterlänge. Bei der Ausführung von Fig. 1 ist vorgesehen, daß die links der Quersymmetrielinie 20b liegenden Anschlußleiter 22 diejenigen Anschlußleiter sind, an denen die Ausgangssignale abgegeben werden. Durch die Versetzung der Trägerplatte in Richtung zur linken Gehäusehälfte, also in Richtung zu den der Abgabe von Ausgangssignalen dienenden Anschlußleitern 22 hin, werden die entsprechenden Leiterstreifen 18 verkürzt, was eine Herabsetzung der jeweiligen Serieninduktivivitäten zur Folge hat.

Da die Trägerplatte 12 einstückig mit dem Masseanschlußleiter 22 über den Leiterstreifen 18 verbunden ist, ist es nicht erforderlich, die Trägerplatte 12 während der Fertigung der integrierten Schaltung, also noch vor der Einbettung in das das Gehäuse 20 bildende Kunststoffmaterial, über Stützstreifen festzuhalten, wie dies bei bisher bekannten integrierten Schaltungen der Fall war. Diese Stützstreifen erstreckten sich von der Trägerplatte aus zur jeweiligen Gehäuseschmalseite, und sie nahmen Platz in Anspruch, der für die Leiterstreifen 18 verlorenging. Bei der Ausgestaltung von Fig. 1 können diese Stützstreifen weggelassen werden, so daß dementsprechend die in Richtung zur Trägerplatte 12 verlaufenden Leiterstreifen 18 breiter ausgeführt werden können. Diese Verbreiterung ergibt eine weitere Herabsetzung der jeweiligen Serieninduktivitäten, was sich besonders bei den Leiterstreifen 18 positiv auswirkt, die die Ausgangssignale zu den entsprechenden Anschlußleitern 22 leiten. In diesen Leiterstreifen fließen nämlich höhere Ströme, die dem entsprechend auch bei entsprechend schnellen Schaltflanken höhere Gegenspannungen induzieren würden, die den gewünschten steilen Schaltflanken entgegenwirken würden.

Die in Fig. 1 dargestellte Ausführungsform der integrierten Schaltung weist somit an allen für die Erzielung steiler Schaltflanken notwendigen Bereichen niedrige Serieninduktivitäten auf, so daß sie ermöglicht, daß die unter Anwendung der modernen CMOS-oder Bipolar-Technologie erzielbaren Schaltgeschwindigkeiten möglichst weitgehend in der Praxis erreicht werden können. Dazu tragen alle oben geschilderten Merkmale bei, nämlich das Versetzen der Trägerplatte 12, das einstükkige Verbinden der Trägerplatte 12 mit dem Masseanschlußleiter 22, das Versetzen der Trägerplatte 12 in Richtung zu den der Abgabe von Ausgangssignalen dienenden Anschlußleitern 22, das Verbreitern der höhere Ströme führenden Leiterstreifen 18. Diese Merkmale müssen nicht stets zusammen angewendet werden, da jedes einzelne bereits eine Herabsetzung der schädlichen Serieninduktivitäten mit sich bringt.

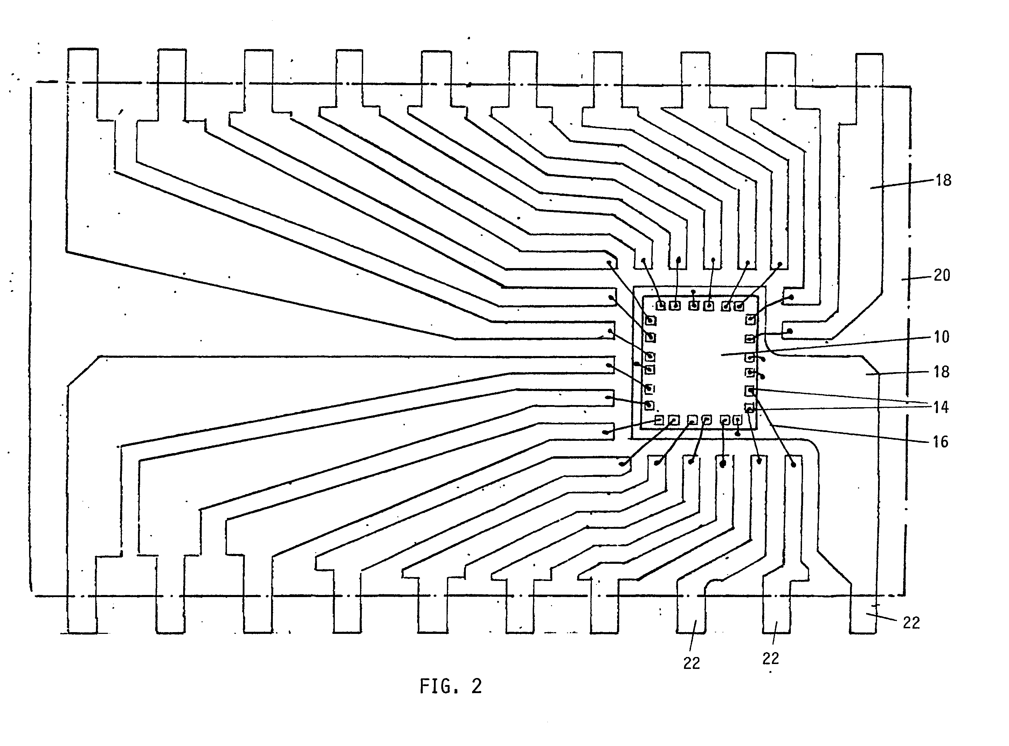

In Fig. 2 ist eine Ausführungsform der Erfindung dargestellt, bei der eine Standardausführung einer integrierten Schaltung zugrundegelegt ist, bei der der Masseanschluß und der mit der positiven Klemme der Versorgungsspannungsquelle zu verbindende Anschlußleiter an diagonal gegenüberliegenden Ecken des Gehäuses 20 liegen. Für gleichartige Teile sind in Fig. 2 jeweils die gleichen Bezugszeichen wie in Fig. 1 verwendet. Der Anschlußleiter, an den Masse angelegt wird, liegt in Fig. 2 rechts unten, und der mit der positiven Klemme der Versorgungsspannungsquelle zu verbindende Anschlußleiter liegt links oben. Im übrigen gilt für die Ausführungsform von Fig. 2 das gleiche, was im Zu sammenhang mit Fig. I beschrieben wurde. Durch das direkte Verbinden der Trägerplatte I2 mit dem Masseanschlußleiter über den Leiterstreifen I8 wird die schädliche Serieninduktivität der Masseleitung herabgesetzt, so daß diese integrierte Schaltung höhere Schaltgeschwindigkeiten, also steilere Schaltflanken, zuläßt.

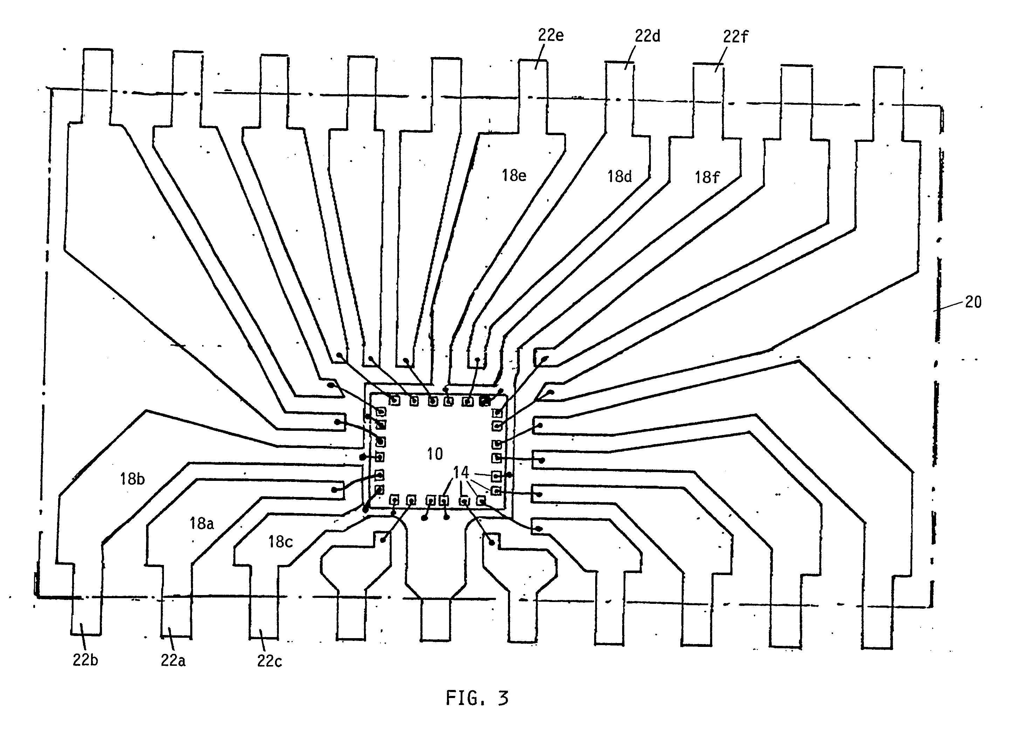

Fig. 3 zeigt eine Ausführungsform einer integrierten Schaltung, die besonders im Hochfrequenzbereich, insbesondere im UHF-Bereich, eingesetzt werden kann. In diesem Bereich wird häufig von sogenannten Streifenleitungen auf gedruckten Schaltungsplatten Gebrauch gemacht, über die Hochfrequenzsignale zu dem diese Signale dann verarbeitenden Halbleiterplättchen I0 in der integrierten Schaltung geleitet werden müssen. Der signalführende Leiter, der in der Hochfrequenztechnik häufig auch als der "heiße" Leiter bezeichnet wird, wird in dieser Ausführungsform von Fig. 3 beispielsweise an den Anschlußleiter 22a angelegt und über den Leiterstreifen I8a dem Halbleiterplättchen I0 zugeführt. Die beiderseits des Leiterstreifens I8a im Gehäuse 20 verlaufenden Leiterstreifen I8b und I8c sind direkt mit der wie in den zuvor beschriebenen Ausführungsbeispielen direkt an Masse gelegten Trägerplatte I2 verbunden, und sie werden über die Anschlußleiter 22b und 22c ebenfalls direkt an Masse gelegt. Sie bewirken daher eine sehr gute Abschirmung des Leiterstreifens I8a, so daß die Anordnung aus den drei Anschlußleitern I8a, I8b und I8c wie eine Fortsetzung einer Streifenleitung oder auch einer Koaxialleitung wirkt, die direkt bis an das Halbleiterplättchen I0 heranführt. Durch geeignete Dimensionierung der Abstände kann sogar erreicht werden, daß auch eine Anpassung an die Impedanz der Zuleitung erzielt wird. Das von der Schaltung im Halbleiterplättchen I0 abgegebene Hochfrequenzsignal kann über den Leiterstreifen I8d dem Anschlußleiter 22d zugeführt werden, wobei die beiderseits des Leiterstreifens I8d verlaufenden Leiterstreifen I8e und I8f direkt mit der Trägerplatte I2 verbunden sind und über die Anschlußleiter 22e und 22f an Masse gelegt sind. Die Gruppe der Leiterstreifen I8d, I8e und I8f verhält sich daher ebenfalls wie eine Streifenleitung oder Koaxialleitung, die direkt bis an das Halbleiterplättchen I0 heranreicht.

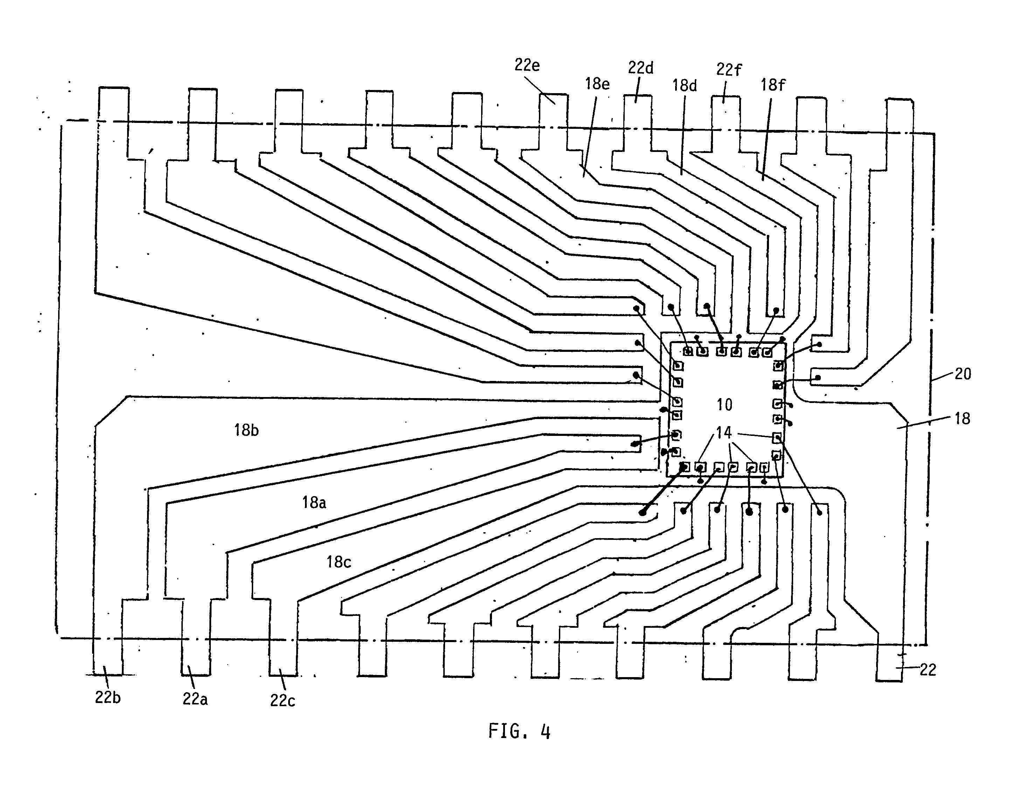

Fig. 4 zeigt die Anwendung der im Zusammenhang mit Fig. 3 beschriebene Idee bei einer integrierten Schaltung, bei der Masse und die Versorgungsspannung am rechts unten liegenden Anschlußleiter bzw. am links oben liegenden Anschlußleiter erfolgt. In Fig. 4 sind wieder gleichartige Teile mit gleichen Bezugszeichen wie in Fig. 3 gekennzeichnet.

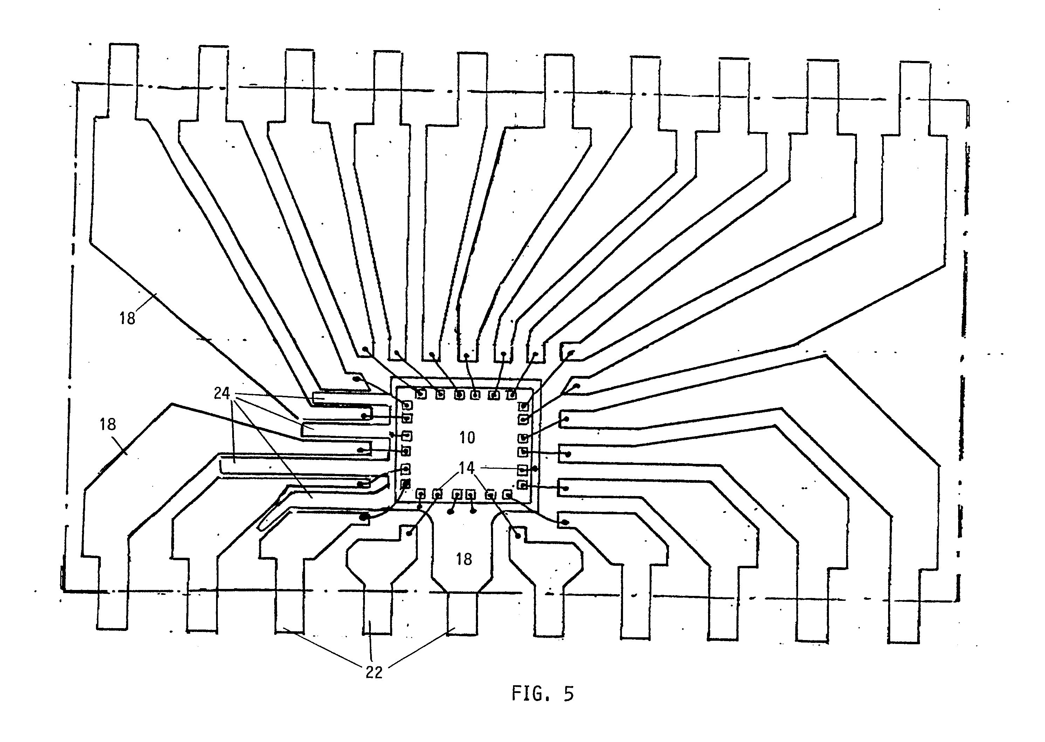

In der Ausführungsform von Fig. 5, die im grundsätzlichen Aufbau der Ausführungsform von Fig. I gleicht, sind zwischen den dem Ableiten von Ausgangssignalen dienenden Anschlußleitern Abschirmleiterstreifen 24 angebracht, die eine Entkopplung der auf den Ausgangs-Leiterstreifen I8 übertragenen Signale bewirken. Ein Nebensprechen zwischen diesen Ausgangs-Leiterstreifen wird dadurch deutlich herabgesetzt. Das Anbringen der Abschirmleiterstreifen 24 wird dadurch ermöglicht, daß, wie oben bereits im Zusammenhang mit Fig. I erwähnt wurde, zum Stützen der Trägerplatte I2 während der Fertigung keine eigenen Stützstreifen mehr erforderlich sind, so daß der entsprechende Platz für das Anbringen der Abschirmleiterstreifen 24 geschaffen wird.

In dem in Fig. 6 dargestellten Schnitt längs der Linie 6-6 von Fig. I ist zu erkennen, wie die Verbindung zwischen der Trägerplatte I2 und einer Masse-Kontaktstelle I4 auf dem Halbleiterplättchen I0 und die Verbindung zwischen einem Leiterstreifen I8 und einer anderen Kontaktstelle I4 über Bonddrähte I6 hergestellt wird. Das Halbleiterplättchen I0 weist ein Substrat 26 aus niederohmigem Halbleitermaterial auf, auf dem eine hochohmige epitaktische Schicht 28 gebildet ist, in der sich die eigentliche elektronische Schaltung befindet. Zwischen der Trägerplatte I2 und dem Halbleiterplättchen I0 befindet sich der aus leitendem Kunststoff bestehende Kleber 30.

Zur Erzielung einer weiteren Verbesserung des Hochfrequenzverhaltens und der Ermöglichung steiler Schaltflanken ist wenigstens eine dem Anlegen von Masse dienende Kontaktstelle I4 über ein entsprechendes Kontaktfenster 32 in der epitaktischen Schicht 28 mit dem Substrat 26 verbunden. Dadurch wird erreicht, daß auch die aktiven Zonen in der hochohmigen epitaktischen Schicht 28 sehr gut an Massepotential gelegt werden und eine niederohmige Verbindung zwischen den betroffenen Zonen durch diese Schicht hindurch über das niederohmige Substrat 26 und der an Masse liegenden Trägerplatte I2 entsteht. Dies dient einer weiteren Verbesserung des Hochfrequenzverhaltens der in der epitaktischen Schicht 28 gebildeten elektronischen Schaltung.

Außerdem bilden die Kontaktierungsflächen und die Verbindungsleitungen auf der Oberfläche des Halbleiterplättchens I0, die mit Masse in Verbindung stehen, mit der Trägerplatte einen Kondensator, der für hohe Frequenzen einen Kurzschluß zwischen den an Masse liegenden aktiven Zonen im Halbleiterplättchen und der Trägerplatte I2 bildet. Die oben erwähnte niederohmige Verbindung zwischen den betroffenen aktiven Zonen und der Trägerplatte I2 bewirkt eine niederohmige Bedämpfung dieses Kondensators, so daß sich keine schädlichen HF-Resonanzerscheinungen ausbilden können.

**Ansprüche**

l. Integrierte Schaltung mit einem eine elektronische Schaltung enthaltenden Halbleiterplättchen, einer Trägerplatte aus elektrisch leitendem Material, auf der das Halbleiterplättchen angebracht ist, im wesentlichen in der Ebene der Trägerplatte angeordneten Leiterstreifen, die sich in Richtung zu der Trägerplatte hin erstrecken und an ihrem von der Trägerplatte abgewandten Ende als Anschlußleiter zum Herstellen von Verbindungen zu externen elektronischen Schaltungen ausgebildet sind, wobei ausgewählte Leiterstreifen mit ausgewählten Punkten der elektronischen Schaltung in dem Halbleiterplättchen in Verbindung stehen, und einem die Trägerplatte, das Halbleiterplättchen und die Leiterstreifen umschließenden Gehäuse, aus dem die Anschlußleiter nach außen ragen, von denen wenigstens einer dem Anlegen von Masse dient, dadurch gekennzeichnet, daß die Trägerplatte (l2) in Richtung zu dem dem Anlegen von Masse dienenden wenigstens einen Anschlußleiter (22) hin versetzt ist.

2. Integrierte Schaltung mit einem eine elektronische Schaltung enthaltenden Halbleiterplättchen, einer Trägerplatte aus elektrisch leitendem Material, auf der das Halbleiterplättchen angebracht ist, im wesentlichen in der Ebene der Trägerplatte angeordneten Leiterstreifen, die sich in Richtung zu der Trägerplatte hin erstrecken und an ihrem von der Trägerplatte abgewandten Ende als Anschlußleiter zum Herstellen von Verbindungen zu externen elektronischen Schaltungen ausgebildet sind, wobei ausgewählte Leiterstreifen mit ausgewählten Punkten der elektronischen Schaltung in dem Halbleiterplättchen in Verbindung stehen, und einem die Trägerplatte, das Halbleiterplättchen und die Leiterstreifen umschließenden Gehäuse, aus dem die Anschlußleiter nach außen ragen, von denen wenigstens einer dem Anlegen von Masse dient, dadurch gekennzeichnet, daß die Trägerplatte (l2) einstückig mit dem dem Anlegen von Masse dienenden wenigstens einen Anschlußleiter (22) verbunden ist.

3. Integrierte Schaltung mit einem eine elektronische Schaltung enthaltenden Halbleiterplättchen, einer Trägerplatte aus elektrisch leitendem Material, auf der das Halbleiterplättchen angebracht ist, im wesentlichen in der Ebene der Trägerplatte angeordneten Leiterstreifen, die sich in Richtung zu der Trägerplatte hin erstrecken und an ihrem von der Trägerplatte abgewandten Ende als Anschlußleiter zum Herstellen von Verbindungen zu externen elektronischen Schaltungen ausgebildet sind, wobei ausgewählte Leiterstreifen mit ausgewählten Punkten der elektronischen Schaltung in dem Halbleiterplättchen in Verbin dung stehen, und einem die Trägerplatte, das Halbleiterplättchen und die Leiterstreifen umschließenden Gehäuse, aus dem die Anschlußleiter nach außen ragen, von denen wenigstens einer dem Anlegen von Masse dient, dadurch gekennzeichnet, daß die Trägerplatte (l2) in Richtung zu dem dem Anlegen von Masse dienenden wenigstens einen Anschlußleiter (22) hin versetzt ist und mit diesem Anschlußleiter (22) einstückig verbunden ist.

4. Integrierte Schaltung nach einem der vorhergehenden Ansprüche, dadurch gekennzeichnet, daß das Gehäuse (20) ein Gehäuse (20) mit rechteckiger Grundform mit einer Längssymmetrieebene (20a) und einer Quersymmetrieebene (20b) ist, bei welchem der dem Anlegen von Masse dienende Anschlußleiter (22) im Bereich der Quersymmetrielinie (20b) angeordnet ist und bei dem dem Anlegen von Eingangssignalen dienende Anschlußleiter (22) auf einer Seite der Quersymmetrielinie (20b) und der Abgabe von Ausgangssignalen dienende Anschlußleiter (22) auf der anderen Seite der Quersymmetrielinie (20b) angeordnet sind, und daß die Trägerplatte (l2) in Richtung zu den der Abgabe von Ausgangssignalen dienenden Anschlußleitern (22) hin versetzt ist.

5. Integrierte Schaltung nach Anspruch 4, dadurch gekennzeichnet, daß die zu den der Abgabe von Ausgangssignalen dienenden Anschlußleitern (22) führenden Leiterstreifen (l8) breiter als die Leiterstreifen sind, die zu den dem Anlegen von Eingangssignalen dienenden Anschlußleitern (22) führen.

6. Integrierte Schaltung nach Anspruch 4 oder 5, dadurch gekennzeichnet, daß in den Zwischenräumen zwischen den Leiterstreifen (l8), die zu den der Abgabe von Ausgangssignalen dienenden Anschlußleitern (22) führen, Abschirmleiterstreifen (24) angebracht sind, die einstückig mit der Trägerplatte (l2) verbunden sind.

7. Integrierte Schaltung nach einem der vorhergehenden Ansprüche, dadurch gekennzeichnet, daß das Halbleiterplättchen (l0) auf der Trägerplatte (l2) ein mit der Trägerplatte (l2) elektrisch leitend verbundenes Substrat (26) aus niederohmigem Halbleitermaterial und auf diesem Substrat (26) eine epitaktische, die eigentliche elektronische Schaltung enthaltende hochohmige Halbleiterschicht (28) aufweist, daß zwischen der Trägerplatte (l2) und wenigstens einem Masseanschlußpunkt der elektronischen Schaltung in der epitaktischen Schicht eine Bondverbindung (l6) gebildet ist und daß wenigstens ein mit der Trägerplatte (l2) in Verbindung stehender Masseanschlußpunkt der elektronischen Schaltung in der epitaktischen Schicht (28) über ein Kontaktfenster (32) in dieser Schicht (28) mit dem Substrat (26) in Verbindung steht.

8. Integrierte Schaltung nach einem der vorhergehenden Ansprüche, dadurch gekennzeichnet, daß die beiderseits wenigstens eines dem Anlegen eines Eingangssignals dienenden Leiterstreifens (l8d) liegenden Leiterstreifen (l8e, l8f) und die beiderseits wenigstens eines der Abgabe von Ausgangssignalen dienenden Leiterstreifens (l8a) liegenden Leiterstreifen (l8b, l8c) einstückig mit der Trägerplatte (l2) verbunden sind.

FIG. 1

FIG. 2

FIG. 3

FIG. 4

0 282 617

FIG. 5

0 282 617

FIG. 6

0 282 617

Europäisches
Patentamt

**EUROPÄISCHER RECHERCHENBERICHT**

Nummer der Anmeldung

EP 87 10 3957

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | PATENT ABSTRACTS OF JAPAN, Band 8, Nr. 91 (E-241)[1528], 26. April 1984; & JP-A-59 10 249 (NIPPON DENKI K.K.) 19-01-1984 * Zusammenfassung * | 2 | H 01 L 23/48 H 01 L 23/56 |
| Y | IDEM | 8 | |
| A | IDEM | 3 | |
| | --- | | |
| X | EP-A-0 198 621 (FUJITSU) * Figuren 9,11; Seite 11, Zeile 26 - Seite 12, Zeile 31 * | 2 | |
| Y | | 8 | |
| A | | 3 | RECHERCHIERTE SACHGEBIETE (Int. Cl.4) |
| | --- | | H 01 L |
| A | PATENT ABSTRACTS OF JAPAN, Band 9, Nr. 244 (E-346)[1967], 30. September 1985; & JP-A-60 94 750 (HITACHI SEISAKUSHO K.K.) 27-05-1985 * Zusammenfassung * | 1,3 | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 28-10-1987 | CAMPLING N.C.G. |

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, Band 8, Nr. 66 (E-234)[1503], 28. März 1984; & JP-A-58 216 451 (HITACHI SEISAKUSHO K.K.) 16-12-1983 * Zusammenfassung * | 4 | |
| A | DE-A-2 556 669 (TOKYO SHIBAURA) | | |
| A | PATENT ABSTRACTS OF JAPAN, Band 10, Nr. 283 (E-440)[2339], 26. September 1986; & JP-A-61 102 054 (TOSHIBA CORP.) 20-05-1986 | | |

RECHERCHIERTE
SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 28-10-1987 | CAMPLING N.C.G. |